(19) Europäisches Patentamt
European Patent Office
Office européen des brevets

(11) **EP 2 669 826 A2**

(12) **EUROPEAN PATENT APPLICATION**

(43) Date of publication:
**04.12.2013 Bulletin 2013/49**

(51) Int Cl.:
***G06F 17/50*** *(2006.01)*

(21) Application number: **13157949.2**

(22) Date of filing: **06.03.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **29.05.2012 US 201213482703**

(71) Applicant: **Livermore Software Technology Corporation**
**Livermore CA 94551 (US)**

(72) Inventors:
• **Zhu, Xinhai**
  **Livermore, CA California 94551 (US)**
• **Zhang, Li**
  **Livermore, CA California 94551 (US)**

(74) Representative: **Becker Kurig Straus**
**Bavariastrasse 7**
**80336 München (DE)**

(54) **Trim line determination in a deep draw manufacturing of a sheet metal part**

(57)    Methods and systems of determining a trim line in deep draw manufacturing of a sheet metal part are disclosed. A computerized model of a sheet metal part and the addendum surface geometry are defined. At least one flange portion in the computerized model is identified. A numerical simulation of unfolding of the flange towards the addendum surface by applying a first set of numerical loads to each pair of adjacent finite elements is performed. The first set of numerical loads is configured for flattening out a given pair of finite elements with a bending moment determined using relative orientations of the pair finite elements and material properties of the part. A second set of numerical loads is applied to close any remaining gap between the unfolded flange and the addendum thereafter. The outer edge of the flange portions in their final unfolded configuration is designated as a trim line.

*FIG. 2*                                                        200

START

202 — Define and receive, in a computer system, a computerized model (FEA model) of a sheet metal part and addendum surface's geometry adjacent to product surface of the die face of a die used in deep draw manufacturing of the sheet metal part

204 — Identify at least one flange portion of the computerized model representing respective at least one flange

206 — Conduct a numerical simulation of unfolding the flange by applying a first set of numerical loads to each pair of adjacent finite elements in the flange portions, the first set of numerical loads are configured for flattening out the pair of finite elements towards the addendum surface with a bending moment determined using material properties and relative orientation the finite elements

208 — apply a second set of numerical loads to the unfolded flange portions to close any gap after the first set of numerical loads has been applied

210 — Designate the outer edge of each of the unfolded flanges of the computerized model as a trim line

END

**Description**

**FIELD OF THE INVENTION**

The present invention generally relates to sheet metal forming, more particularly to determination of a trim line in a deep draw manufacturing of a sheet metal part by conducting a numerical simulation of unfolding flange of a computerized model (e.g., a finite element analysis (FEA) model) of the sheet metal part.

**BACKGROUND OF THE INVENTION**

Sheet metal forming has been used in the industry for years for creating metal parts from a blank sheet metal, for example, automobile manufacturers and their suppliers produce many parts using sheet metal forming.

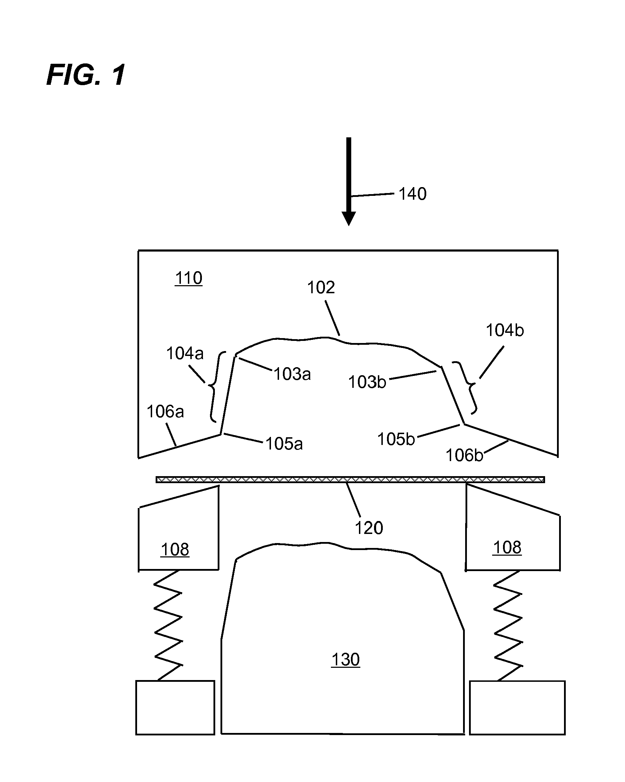

One of the most used sheet metal forming processes is deep drawing, which involves a hydraulic or mechanical press pushing a specially-shaped punch into a matching die with a piece of blank sheet metal in between. Exemplary products made from this process include, but are not limited to, car hood, fender, door, automotive fuel tank, kitchen sink, aluminum can, etc. In some areas of the die, the depth of a part or product being made is generally more than half its diameter. As a result, the blank is stretched and therefore thinned in various locations due to the geometry of the part or product. The part or product is only good when there is no structural defect such as material failure (e.g., cracking, tearing, wrinkling, necking, etc.). In order to produce a part free of these defects, it is critical to design an addendum section between the product design and the binder region. FIG. 1 is a diagram illustrating an elevation view of cross-section of an exemplary set up of a draw die for sheet metal forming.

Shown in FIG. 1, a sheet metal blank or blank 120 (i.e., an unformed sheet metal plate before being formed) is rest on a blank holder 108 between an upper die cavity 110 and a punch 130. The blank 110 is formed into a sheet metal part when the die 110 is pushed down to the punch 130 in the direction of the draw axis (shown by an arrow 140). The die 110 has a product design section 102, binder section 106a-b and addendum section 104a-b. The boundary between the addendum section 104a-b and the  design surface section 102 is referred to as a trim line 103a-b, while the direct intersection between the addendum sections 104a-b and the binder section 106a-b is referred to as theoretical punch opening line 105a-b. Trim lines are mostly enclosed and there can be more than one enclosed trim lines in a sheet metal part. It is possible to have more than one hundred enclosed trim lines for forming a complex sheet metal part.

Product surface contains the desired pattern/shape of a sheet metal part at the end of the forming process followed by a trimming operation. Binder section is configured for holding the blank during the forming process. Addendum section provides a buffer or transition zone between the product design surface section and the binder section. After the blank is shaped by the punch, the sheet metal part is cut out along the enclosed trim lines.

A well or properly defined trim line allows the manufacturer to convert a blank into its final configuration either directly or faster hence significantly reducing the manufacturing costs of a sheet metal part. Prior art approaches of determining a trim line have been mainly dependent upon human experience or at best on an ad-hoc procedure based on trial-and-error. It would therefore be desirable to have methods of determining a trim line of a sheet metal part using a computer simulation.

**BRIEF SUMMARY OF THE INVENTION**

Improved systems and methods of determining a trim line of a sheet metal part during its manufacturing procedure using a numerical simulation of unfolding flange of a computerized model are disclosed. The computerized model is suitable for a numerical simulation of deep draw sheet metal stamping process using computer aided engineering analysis (e.g., finite element analysis (FEA)) in a computer system.

According to one exemplary embodiment of the present invention, a computerized model of a sheet metal part is defined and received in a computer system having a FEA application module installed thereon. Also received in the computer system is a three-dimensional geometry of the addendum surface adjacent to product surface of the die face. At least one flange portion in the computerized model is identified. Perform a numerical simulation of unfolding of the flange portion by  applying a first set of numerical loads to each pair of adjacent finite elements in the flange portions towards the addendum surface. The first set of numerical loads is configured for flattening out the pair of finite elements with a bending moment, which is determined using relative orientations of the pair of finite elements and material properties of the sheet metal part. A second set of numerical loads is applied to close any remaining gap between the unfolded flange and the addendum surface after the first set of numerical loads has been applied. A theoretical trim line is a three-dimensional closed curve disposed on the addendum surface depicting the outer edge of the flange portions in their final unfolded configuration.

Objects, features, and advantages of the present invention will become apparent upon examining the following detailed description of an embodiment thereof, taken in conjunction with the attached drawings.

## BRIEF DESCRIPTION OF THE DRAWINGS

These and other features, aspects, and advantages of the present invention will be better understood with regard to the following description, appended claims, and accompanying drawings as follows:

FIG. 1 is a diagram showing an elevation cross-section view of an exemplary set up of a draw die for deep draw manufacturing of a sheet metal part;

FIG. 2 is a flowchart illustrating an exemplary process of determining a trim line used in deep draw manufacturing of a sheet metal part, according to an embodiment of the present invention;

FIGS. 3A-3B are diagrams illustrating cross-sectional profiles of a deep draw manufacturing die with a sheet metal part before and after a numerical simulation of unfolding a flange in accordance with one embodiment of the present invention;

FIG. 4 is a perspective view showing a section of an exemplary addendum surface adjacent to a product surface of the die face, according to an embodiment of the present invention;

FIG. 5 shows diagrams of exemplary geometrical relationships used for determining a first set numerical loads (bending moment) in a flange unfolding simulation, according to an embodiment of the present invention;

FIG. 6 is a diagram showing a second set of numerical loads is applied to the unfolded flange for closing a gap after the first set of numerical loads has been applied, according to an embodiment of the present invention;

FIG. 7 is a diagram showing another exemplary cross-sectional profile of a deep draw manufacturing die with a sheet metal part in which a flange is located in the interior of the sheet metal part, according to another embodiment of the present invention; and

FIG. 8 is a functional block diagram showing salient components of an exemplary computer, in which an embodiment of the present invention may be implemented.

## DETAILED DESCRIPTION

The present invention is directed to an improved method of creating a computerized numerical model representing addendum section. The computerized numerical model is suitable for a computer simulation of a sheet metal forming process using computer aided engineering analysis (e.g., finite element analysis).

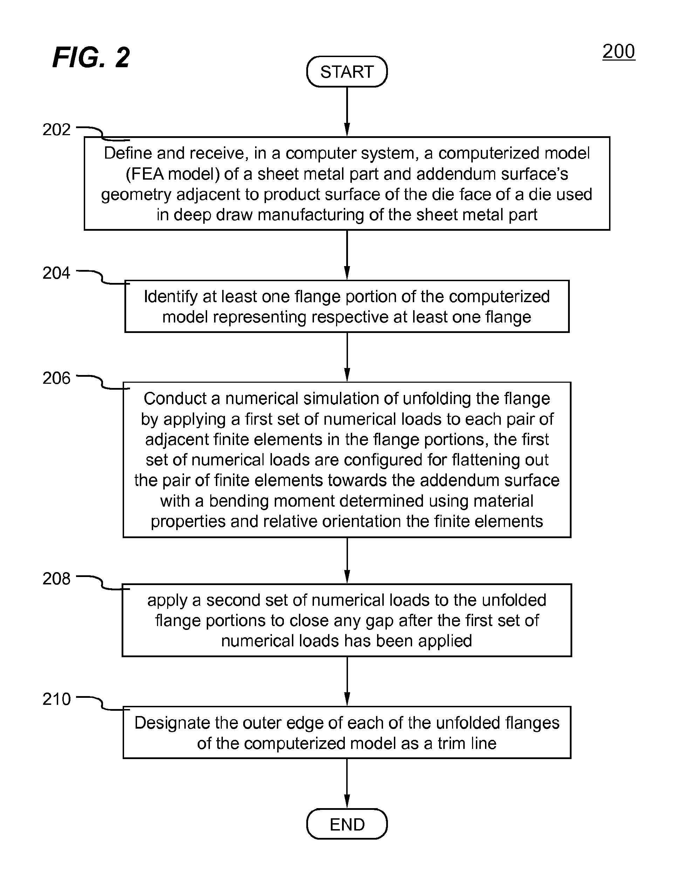

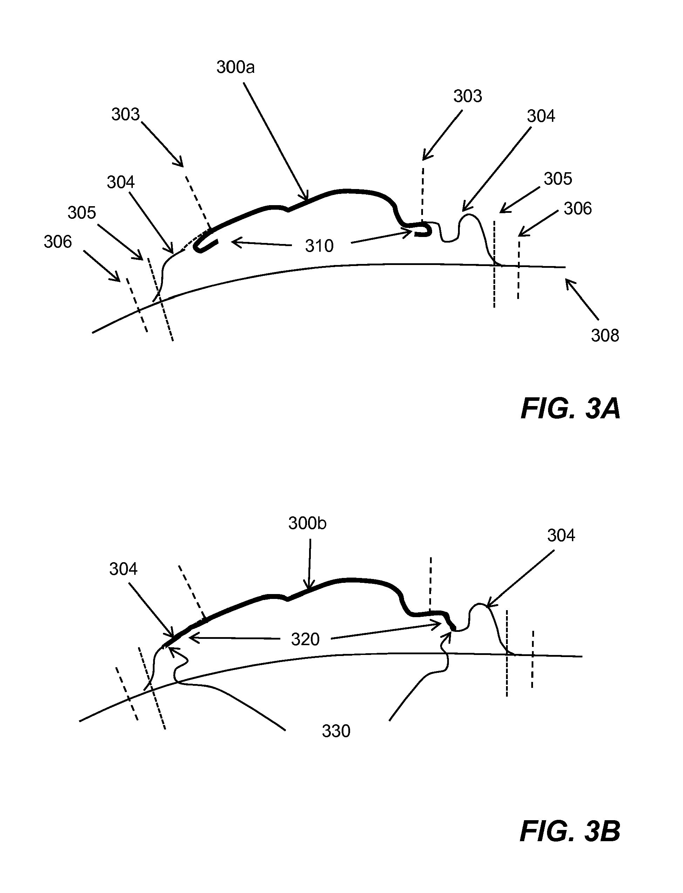

Referring first to FIG. 2, it is shown an exemplary process 200 of determining a trim line used in deep draw manufacturing of a sheet metal part. Process 200 may be implemented in software and preferably understood with other figures, for example, FIGS. 3-8.

Process 200 starts at step 202 by defining and receiving a computerized model of a sheet metal part's final or any intermediate manufactured configuration and an addendum surface three-dimensional geometry in a computer system. Next, at step 204, at least one flange portion of the computerized model is identified. The flange portions represent respective flanges of the sheet metal part. There can be more than one flange in a sheet metal part, for example, one along the outer perimeter, another along an inner opening. One exemplary computerized model is a finite element analysis (FEA) model, which contains a number of finite elements. Typical finite elements for representing sheet metal part are three-dimensional shell finite elements.

A section profile of an exemplary deep draw manufacturing setup with a sheet metal part 300a (shown in thick black line) in its final or finished configuration is shown in FIG. 3A. An addendum 304 is shown surrounding a product surface at product surface extension position 303. A flange 310 starts from the produce surface extension position 303 to the outer perimeter of the finished sheet metal part 300a. Also shown in FIG. 3A are binder surface 308, theoretical punch opening 305 and bead center line 306.

At step 206, process 200 conducts a numerical simulation (i.e., computer simulation using FEA) of unfolding the flange or flanges of the sheet metal part by applying a first set of numerical loads to each pair of adjacent finite elements in the identified flange portions. The first set of numerical loads is configured for flattening out each pair of finite elements towards the respective addendum surface with a bending moment, which is determined using relative orientation of the pair of finite elements and material properties of the sheet metal part (e.g., thickness, elasticity modulus of the sheet metal, and strain hardening properties, etc.).

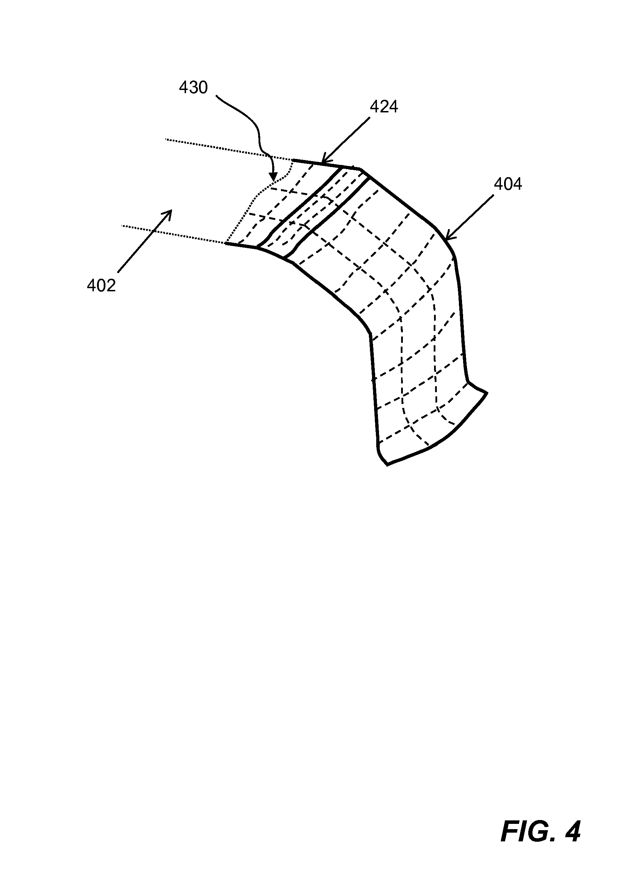

FIG. 3B shows a profile as a result of unfolding simulation of the configuration shown in FIG. 3A. The unfolded flange 320 of the sheet metal part 300b is shown coincided with the addendum surface 304. The outer perimeter or edge 330 is a trim line predicted or determined in accordance with one embodiment of the present invention. A perspective view shown in FIG. 4 demonstrates the relationship between a portion of an exemplary addendum surface 404, product surface 402, and a trim line 430 located on a tangential extension 424 (a part of addendum) of the product surface 402.

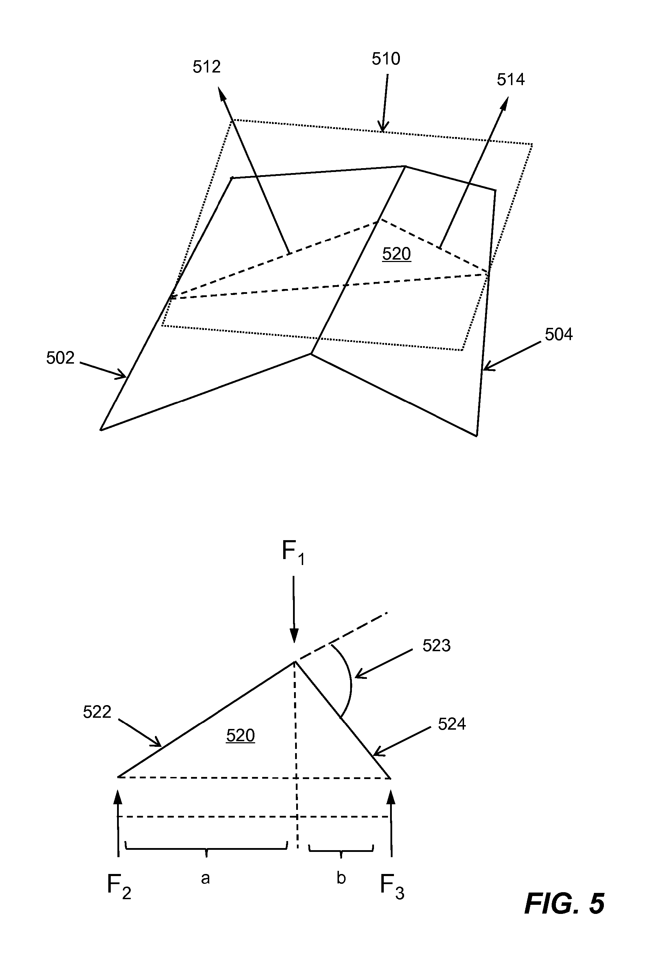

FIG. 5 shows diagrams of exemplary geometrical relationships used in determining the first set of numerical loads (i.e., bending moment) for flattening out the pair of adjacent finite elements 502-504. A plane 510 containing respective normal vectors 512-514 of the pair of finite elements 502-504 is established. A triangle 520 is formed with intersection points between edges of the finite elements and the plane 510. The relative orientation of finite elements 502-504 comprises the relative angle 523 between two sides 522-524 of the triangle 520. Sides 522 and 524 are intersection lines between the plane 510 and shell finite elements 502 and 504, respectively. In one embodiment, the first set of numerical loads is direct proportion to the relative angle 523. When the relative angle 523 equals zero or two finite elements 502-504 are coplanar, the first set of numerical loads is zero. In other words, there is no need for flatten the pair of shell finite elements, because they are already flatten. In order to maintain as a bending moment, the first set of numerical loads ($F_1$, $F_2$ and $F_3$ shown in FIG. 5) is configured to satisfy the following equations:

$$F_1 = F_2 + F_3$$

$$F_2 \times a = F_3 \times b$$

where $F_1$ is a numerical load at the intersection between two finite elements, $F_2$ and $F_3$ are numerical loads located at other corners of triangle 520 opposite to $F_1$, "a" and "b" are projected distances from $F_1$ to $F_2$ and $F_3$, respectively.

Further, user can gradually or incrementally apply the numerical loads to the computerized model in a flange unfolding simulation to maintain numerical stability or accuracy required in FEA. Those of ordinary skill in the art would appreciate such known techniques or schemes.

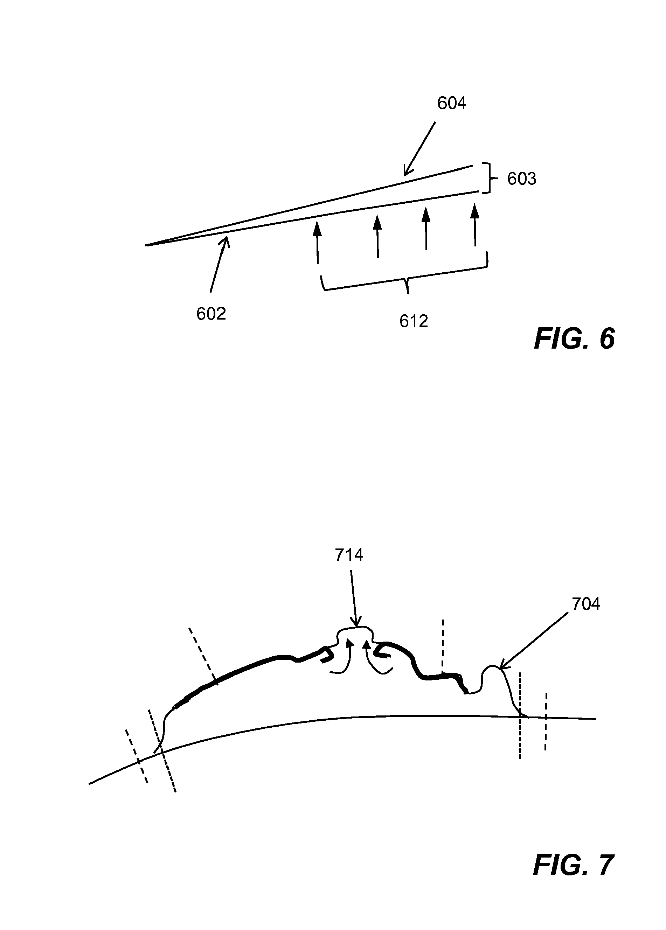

Referring back to FIG. 2, after the first set of numerical loads has been applied, process 200 optionally applies a second set of numerical loads to close any remaining gap between the unfolded flange and the addendum surface at step 208. FIG. 6 shows an exemplary gap 603 between unfolded flange 602 and addendum surface 604, and a second set of numerical loads 612.

Finally, at step 210, the outer edge of the final unfolded configuration of the flange portions of the computerized model is designated as a trim line before process 200 ends. The trim line is a three-dimensional curve disposed on the addendum surface.

FIG. 7 shows a sheet metal part's profile having two flanges unfolded to addendum areas 704 and 714. In another example, there can be more flanges hence more trim lines.

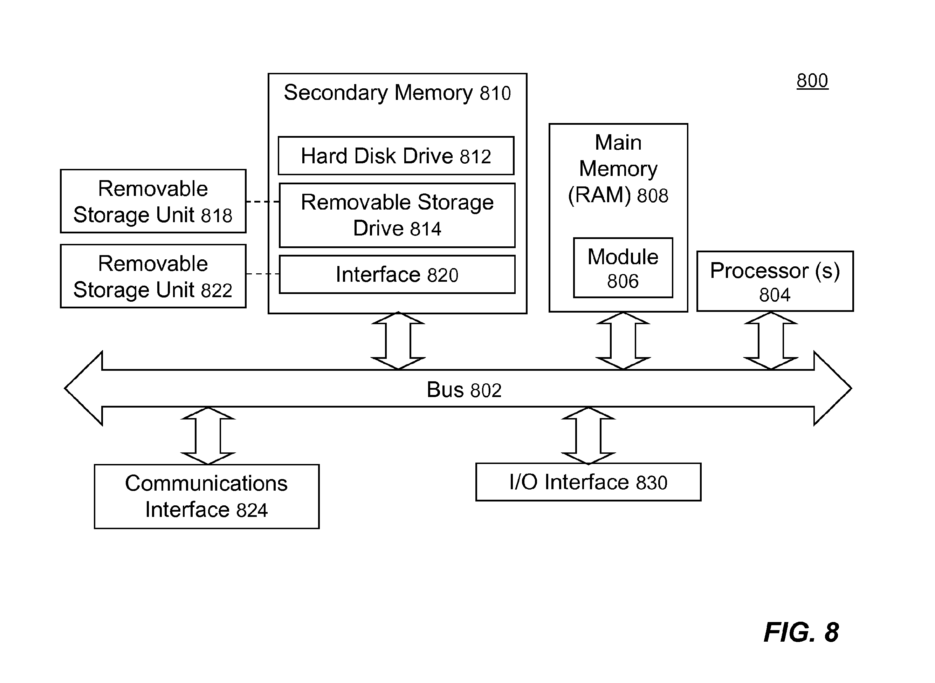

According to one aspect, the present invention is directed towards one or more computer systems capable of carrying out the functionality described herein. An example of a computer system 800 is shown in FIG. 8. The computer system 800 includes one or more processors, such as processor 804. The processor 804 is connected to a computer system internal communication bus 802. Various software embodiments are described in terms of this exemplary computer system. After reading this description, it will become apparent to a person skilled in the relevant art(s) how to implement the invention using other computer systems and/or computer architectures.

Computer system 800 also includes a main memory 808, preferably random access memory (RAM), and may also include a secondary memory 810. The secondary memory 810 may include, for example, one or more hard disk drives 812 and/or one or more removable storage drives 814, representing a floppy disk drive, a magnetic tape drive, an optical disk drive, etc. The removable storage drive 814 reads from and/or writes to a removable storage unit 818 in a well-known manner. Removable storage unit 818, represents a floppy disk, magnetic tape, optical disk, etc. which is read by and written to by removable storage drive 814. As will be appreciated, the removable storage unit 818 includes a computer usable storage medium having stored therein computer software and/or data.

In alternative embodiments, secondary memory 810 may include other similar means for allowing computer programs or other instructions to be loaded into computer system 800. Such means may include, for example, a removable storage unit 822 and an interface 820. Examples of such may include a program cartridge and cartridge interface (such as that found in video game devices), a removable memory chip (such as an Erasable Programmable Read-Only Memory (EPROM), Universal Serial Bus (USB) flash memory, or PROM) and associated socket, and other removable storage units 822 and interfaces 820 which allow software and data to be transferred from the removable storage unit 822 to computer system 800. In general, Computer system 800 is controlled and coordinated by operating system (OS) software, which performs tasks such as process scheduling, memory management, networking and I/O services.

There may also be a communications interface 824 connecting to the bus 802. Communications interface 824 allows software and data to be transferred between computer system 800 and external devices. Examples of communications interface 824 may include a modem, a network interface (such as an Ethernet card), a communications port, a Personal Computer Memory Card International Association (PCMCIA) slot and card, etc. Software and data transferred via communications interface 824 are in the form of signals 828 which may be electronic, electromagnetic, optical, or other signals capable of being received by communications interface 824. The computer 800 communicates with other computing devices over a data network based on a special set of rules (i.e., a protocol). One of the common protocols is TCP/IP (Transmission Control Protocol/Internet Protocol) commonly used in the Internet. In general, the communication interface 824 manages the assembling of a data file into smaller packets that are transmitted over the data network or reassembles received packets into the original data file. In addition, the communication interface 824 handles the address part of each packet so that it gets to the right destination or intercepts packets destined for the computer 800.In this document, the terms "computer program medium" and "computer usable medium" are used to generally refer to media such as removable storage drive 814, and/or a hard disk installed in hard disk drive 812. These computer program products are means for providing software to computer system 800. The invention is directed to such computer program products.

The computer system 800 may also include an input/output (I/O) interface 830, which provides the computer system 800 to access monitor, keyboard, mouse, printer, scanner, plotter, and alike.

Computer programs (also called computer control logic) are stored as application modules 806 in main memory 808 and/or secondary memory 810. Computer programs may also be received via communications interface 824. Such computer programs, when executed, enable the computer system 800 to perform the features of the present invention as discussed herein. In particular, the computer programs, when executed, enable the processor 804 to perform features of the present invention. Accordingly, such computer programs represent controllers of the computer system 800.

In an embodiment where the invention is implemented using software, the software may be stored in a computer program product and loaded into computer system 800 using removable storage drive 814, hard drive 812, or communications interface 824. The application module 806, when executed by the processor 804, causes the processor 804 to perform the functions of the invention as described herein.

The main memory 808 may be loaded with one or more application modules 806 that can be executed by one or more processors 804 with or without a user input through the I/O interface 830 to achieve desired tasks. In operation, when at least one processor 804 executes one of the application modules 806, the results are computed and stored in the secondary memory 810 (i.e., hard disk drive 812). The status of the computer simulation of sheet metal forming process (e.g., finite element analysis results) is reported to the user via the I/O interface 830 either in a text or in a graphical representation.

Although the present invention has been described with reference to specific embodiments thereof, these embodiments are merely illustrative, and not restrictive of, the present invention. Various modifications or changes to the specifically disclosed exemplary embodiments will be suggested to persons skilled in the art. For example, whereas only one or two flanges have been described and shown, other numbers of flanges are likely in the real world parts. In summary, the scope of the invention should not be restricted to the specific exemplary embodiments disclosed herein, and all modifications that are readily suggested to those of ordinary skill in the art should be included within the spirit and purview of this application and scope of the appended claims.

## Claims

1. A method of determining a trim line used in deep draw manufacturing of a sheet metal part, said method comprising:

   defining and receiving, in a computer system, a finite element analysis (FEA) model of a sheet metal part and an addendum surface geometry, where the addendum surface is located adjacent to a product surface of a draw die used in deep draw manufacturing of said sheet metal part;
   identifying a plurality of shell finite elements as at least one flange portion of the FEA model representing at least one flange of the sheet metal part;
   conducting a numerical simulation of unfolding said at least one flange by applying a first set of numerical loads to the plurality of shell finite elements, the first set of numerical loads being configured for flattening out each pair of adjacent finite elements towards the addendum surface with a bending moment determined using relative orientations of said each pair of the adjacent finite elements and material properties of said sheet metal part;
   applying a second set of numerical loads to said at least one flange portion of the first FEA model to close any remaining gap between said unfolded flange portion and the addendum surface thereafter; and
   designating said unfolded flange portion's outer edge as a trim line used in deep draw manufacturing of said sheet metal part.

2. The method of claim 1, wherein said applying the first set of numerical loads is conducted in a number of incremental steps with each step containing a fraction of the first set of numerical loads.

3. The method of claim 1, wherein the relative orientations of said each pair of the adjacent finite elements comprise a relative angle between the adjacent finite elements.

4. The method of claim 3, wherein said first set of numerical loads is direct proportion of the relative angle.

5. The method of claim 4, wherein the relative angle is determined from respective intersection lines of the adjacent finite elements and a plane that contains respective normal vectors of said adjacent finite elements.

6. The method of claim 5, wherein the bending moment is determined with a triangle's geometry on the plane, wherein the triangle is formed by three intersection points between said adjacent finite element's edges and the plane.

7. The method of claim 1, wherein said material properties comprise thickness, elasticity modulus, and strain hardening properties of the sheet metal part.

8. The method of claim 1, wherein said trim line comprises a closed curve in a three-dimensional space.

9. The method of claim 1, wherein the FEA model represents final or any intermediate manufactured configuration of the sheet metal part.

10. A system for of determining a trim line used in deep draw manufacturing of a sheet metal part, said system comprising:

an input/output (I/O) interface;
a memory for storing computer readable code for an application module;
at least one processor coupled to the memory, said at least one processor executing the computer readable code in the memory to cause the application module to perform operations of:
defining and receiving a finite element analysis (FEA) model of a sheet metal part and an addendum surface geometry, where the addendum surface is located adjacent to a product surface of a draw die used in deep draw manufacturing of said sheet metal part;
identifying a plurality of shell finite elements as at least one flange portion of the FEA model representing at least one flange of the sheet metal part;
conducting a numerical simulation of unfolding said at least one flange by applying a first set of numerical loads to the plurality of shell finite elements, the first set of numerical loads being configured for flattening out each pair of adjacent finite elements towards the addendum surface with a bending moment determined using relative orientations of said each pair of the adjacent finite elements and material properties of said sheet metal part;
applying a second set of numerical loads to said at least one flange portion of the first FEA model to close any remaining gap between said unfolded flange portion and the addendum surface thereafter; and
designating said unfolded flange portion's outer edge as a trim line used in deep draw manufacturing of said sheet metal part.

11. A non-transitory computer readable medium containing computer executable instructions of determining a trim line used in deep draw manufacturing of a sheet metal part by a method comprising:

defining and receiving, in a computer system, a finite element analysis (FEA) model of a sheet metal part and an addendum surface geometry, where the addendum surface is located adjacent to a product surface of a draw die used in deep draw manufacturing of said sheet metal part;
identifying a plurality of shell finite elements as at least one flange portion of the FEA model representing at least one flange of the sheet metal part;
conducting a numerical simulation of unfolding said at least one flange by applying a first set of numerical loads to the plurality of shell finite elements, the first set of numerical loads being configured for flattening out each pair of adjacent finite elements towards the addendum surface with a bending moment determined using relative orientations of said each pair of the adjacent finite elements and material properties of said sheet metal part;
applying a second set of numerical loads to said at least one flange portion of the first FEA model to close any remaining gap between said unfolded flange portion and the addendum surface thereafter; and
designating said unfolded flange portion's outer edge as a trim line used in deep draw manufacturing of said sheet metal part.

# FIG. 1

**FIG. 2**                                                                      200

START

202 — Define and receive, in a computer system, a computerized model (FEA model) of a sheet metal part and addendum surface's geometry adjacent to product surface of the die face of a die used in deep draw manufacturing of the sheet metal part

204 — Identify at least one flange portion of the computerized model representing respective at least one flange

206 — Conduct a numerical simulation of unfolding the flange by applying a first set of numerical loads to each pair of adjacent finite elements in the flange portions, the first set of numerical loads are configured for flattening out the pair of finite elements towards the addendum surface with a bending moment determined using material properties and relative orientation the finite elements

208 — apply a second set of numerical loads to the unfolded flange portions to close any gap after the first set of numerical loads has been applied

210 — Designate the outer edge of each of the unfolded flanges of the computerized model as a trim line

END

FIG. 3A

FIG. 3B

**FIG. 4**

**FIG. 5**

**FIG. 6**

**FIG. 7**

FIG. 8